# EUROPEAN PATENT APPLICATION

(11) **EP 4 657 160 A1**
(43) Date of publication of application: **03.12.2025**
(21) Application number: 24178211.9
(22) Date of filing: 27.05.2024
(51) Int. Cl.: G03F 7/20, G03F 7/24

(54) **METHOD AND APPARATUS FOR ATOMATED PLATE PROCESSING**

(71) Applicant: Esko-Graphics Imaging GmbH, 25524 Itzehoe (DE)
(72) Inventor: Sievers, Wolfgang, CH-8105 Regensdorf (CH)
(74) Representative: Jonas, Hans-Hermann

(57) **Abstract**

A method and apparatus for processing a photopolymer printing plate precursor. A drum is configured to receive and hold the plate precursor during some processing operations. A plate holder is arranged tangentially adjacent to the drum for receiving the plate during precursor loading and/or unloading, and a controller is configured to control execution of the plate processing operations. Backside curing is performed while the plate precursor is disposed on the plate holder, and imaging, frontside curing, uncured photopolymer removal, aftertreatment, and optional detacking are performed with the plate precursor disposed on the drum.

## Description

### BACKGROUND OF THE INVENTION

Flexographic printing has become a standard print technology used in many areas of printing, including but not limited to packaging printing. The number of flexographic printing plates consumed per year has continuously increased in recent years and printing quality has improved such that flexographic printing has replaced gravure and offset printing in many printing applications. The simplicity of the production process is one advantage that flexographic printing enjoys as compared to gravure and offset printing.

With increasing environmental requirements, statutory limitations on printing processes and printing plate creation processes have been enacted or are coming soon, and platemakers and printers proactively are working to be more environmentally friendly, including but not limited to limiting the use of mercury-containing components, reduction in the use of hydrocarbon solvents, and reduction in the amount of waste (including wastewater) generated. Speed and handling simplicity in the plate manufacturing process have always been and continue to be valued.

Digital flexographic printing plates that allow the transfer of images from a data file to the plate by means of laser ablation using a Laser ablate-able Mask System (LAMS) have replaced older film-based technologies. Thermal processing of plates (to remove uncured photopolymer after imaging and exposure steps) continues to gain more market share, as this type of processing avoids the use of solvents considered potentially hazardous to human print shop operators and/or the environment. UV LEDs instead of UV fluorescent tubes (which historically contain mercury) is becoming state-of -the-art.

Thus, future production of flexographic printing plates is merging toward certain preferences, including:
- using digital printing plates;
- using laser imaging;
- using UV LED curing devices;
- using thermal processing; and
- automated process workflow.

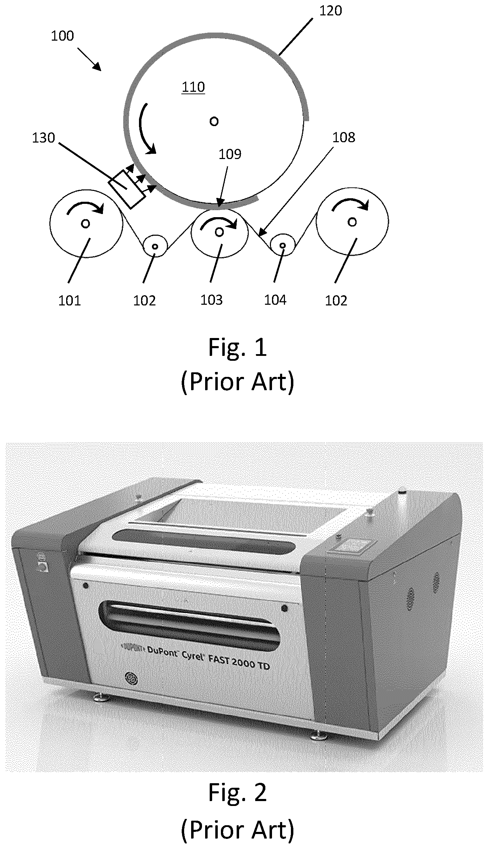

Thermal processing systems for removing uncured polymer from a printing plate precursor are known in the art. Fig. 1 depicts an exemplary such thermal processor having a central drum 110 with means (not shown, but well known in the art) for attaching the photopolymer plate 130 to the drum for processing. On an underside of drum 110, a web supply roller 101, a web pressure roller 103, and a web waste roller 105 are arranged, as well as one or more web guiding rollers, represented by rollers 102 and 104 in FIG. 1, all of which can be characterized as being part of a web transport system arranged to transport web 108 to and from a contact area 109 with plate 130 mounted on the drum 110. Pressure roller 103 is configured to apply pressure to bias the web 108 against the plate 130, both of which are disposed between the pressure roller 103 and the drum 110 (which may have a conformable material -- e.g., having a compression modulus between 3 and 1500 psi -- disposed on an outer surface of the drum beneath the plate). Likewise, the pressure roller may comprise a conformable material or may comprise a rigid base with a layer of conformable material disposed thereon. Each drum or roller is configured to rotate in the direction of the arrow depicted thereon in FIG. 1.

Heat radiation source 130 is arranged to heat the plate in a location sequentially before the contact area 109 between the web and the plate in the direction of drum rotation. The photopolymer is heated to a temperature that brings the non-cured portions of polymer close to the melting point such that the uncured polymer starts to liquify, whereas the cured polymer has a higher melting temperature and remains solid. The liquified or near-liquified, uncured polymer is then removed by the web, which is typically moved along the plate surface at the same speed as the plate. The web pressure roller is adjustable in distance relative to the surface of the drum. This adjustability allows rotating the drum for loading the plate without contacting the web pressure roller to the plate and permits adjusting the pressure exerted by the web on the plate to different plate thicknesses and a desired intermediate depth of the non-printing areas on the plate. In most systems, the photopolymer plate is removably fixed by means of clamps onto the drum, but any number of fixation mechanism are known.

Fig. 2 is a photograph of a common thermal processor that operates according to the principles described above. This device as depicted is used for plate sizes of 42 x 60 inches and has a footprint of 2.2 x 1.8 meters. As shown, the device includes an enclosure that encloses drum as well as the web and web-transport system associated with the thermal processing system.

Advances in the automation of the plate manufacturing processes are still under development. In contemporary workflow solutions, separate apparatus are typically used to perform the following individual process steps of:
- imaging the plate;
- curing the plate; and
- removing the non-cured polymer.

An exemplary process workflow using separate apparatus can be found in the combination of a laser-based Cyrel^{®} Digital Imager (CDI) (made by Esko-Graphics Imaging GmbH), followed by an XPS^{™} UV exposure unit (also made by Esko), and a DuPont^{®} thermal processor. Each of these devices needs, on average, about 4 m² of floor space. This is often too much for smaller companies, where operators manually organize the transfer of the in-process plate from one device to the next, which therefore also uses additional floorspace for the movement of the operators. Automated transfer from one device to the next is often based on electronic data exchange among machines, but this communication can suffer from reliability challenges due to network problems or interface problems between or among the individual devices.

Thus, there is a need for an improved solution that requires less floor space, less operator intervention, and that has improved coordination of the individual process steps.

While integrated systems for manufacturing a printing plate from a plate precursor in a single apparatus have been previously proposed, such as in WO2023/089374, titled UVC LED LIGHT FINISHER FOR DETACKING FLEXOGRAPHIC PRINTING PLATES, assigned to the assignee of the present invention and incorporated herein by reference, such systems describe applying backside radiation through the wall of a transparent drum, which adds undesirable complexities to the apparatus.

### SUMMARY OF THE INVENTION

One aspect of the invention relates to an apparatus for processing a photopolymer printing plate precursor having a frontside and a backside, a photopolymer layer and a Laser Ablatable Mask system (LAMs) layer on the frontside of the plate precursor. The apparatus comprises a drum configured to receive and hold the plate precursor during at least some of a plurality of plate precursor processing operations, a plate holder arranged tangentially adjacent to the drum for receiving the backside of the plate precursor during a loading and/or unloading step of the plate, and a controller configured to control execution of the plurality plate precursor processing operations by the apparatus. The apparatus comprises at least one first radiation source configured to emit actinic UVA radiation during a backside curing operation, a laser imaging system, at least one second radiation source configured to emit actinic UVA radiation during a frontside curing operation, a processing system configured to perform an uncured photopolymer removal operation, at least one third radiation source (which may be the same as the second radiation source) configured to emit actinic UVA radiation during an aftertreatment operation, and optionally at least one fourth radiation source configured to emit actinic UVC radiation during a detacking operation. The first radiation source is configured to expose first portions of the photopolymer plate precursor performed with the backside of the plate precursor disposed at least in part on the plate holder with the first radiation source positioned beneath the plate holder and arranged to emit radiation through a window in the plate holder onto the plate precursor backside. The laser imaging system includes one or more laser light sources configured for laser imaging the LAMS layer during an imaging operation performed with the plate precursor disposed on the drum. The frontside curing operation is performed on second portions of the photopolymer plate precursor through the imaged LAMS layer with the plate precursor disposed on the drum. The processing system is configured to remove the uncured photopolymer from the plate precursor with the plate precursor disposed on the drum. The aftertreatment operation and the optional detacking operation are also performed with the plate precursor disposed on the drum. The fourth radiation source optionally comprises a plurality of LEDs or fluorescent tubes. Each of the first, second, and third radiation sources may also comprise a plurality of LEDs.

In embodiments, the plate holder has a length suitable to accept an entire length of the plate precursor, wherein the apparatus, including the controller, is configured to perform the backside curing operation during unloading of the plate from the drum. The window in the plate holder may comprise a material at least partially transparent to the actinic radiation emitted by the first radiation source. The apparatus may include a moveable bar equipped with suction cups operable to removably attach the suction cups to the frontside of the plate precursor, the bar configured to move relative to the plate holder and configured to perform the back exposure of the plate by dragging the plate over the window during the backside exposure operation. Embodiments may include a plate fixation system disposed on the drum that interfaces with a mating plate fixation mechanism on the plate precursor, wherein the plate fixation mechanism disposed on the plate precursor is also suitable for fixing an ink-ready printing plate formed from the plate precursor to a printing cylinder of a printing press.

The first radiation source and the second radiation source may comprise a single radiation source having a first configuration aimed toward the window in the plate holder and a second configuration aimed toward the drum. The plate holder may have a first solid portion and a second solid portion, wherein the window comprises an opening in which are disposed a first pair of nip rollers adjacent the first solid portion and a second pair of nip rollers adjacent the second solid portion, each of the first pair and the second pair configured to receive the plate precursor therebetween, wherein the first radiation source is disposed between the first pair of nip rollers and the second pair of nip rollers.

In embodiments, the processing system for removing uncured photopolymer may comprise a thermal processing system. Thermal processing system embodiments may have a roller system configured to transport a web to and from a contact area between the plate and the web, the contact area located between a pressure roller and the drum, and a heater disposed sequentially before the contact area, wherein the heater is configured to heat the plate precursor to a temperature at which uncured polymer in the plate precursor is liquified or otherwise disposed to detach from the plate precursor and attach to the web but at which the cured polymer remains in a solid state disposed to remain attached to the plate precursor. The drum may have a cooling system for maintaining a temperature of the drum at a desired temperature during repeated heating of the plate mounted on the drum, optionally further comprising an enclosure surrounding at least the drum, and a fume evacuation system configured to remove fumes and/or particulate from within the enclosure during performance of the imaging operation.

In some embodiments, the apparatus, including the controller, is configured to execute the backside curing operation before the plate is loaded on the drum. In other embodiments, the apparatus, including the controller, may be configured to execute the backside curing operation sequentially after performance of the plate imaging operation and before the frontside curing operation.

Another aspect of the invention relates to a method for processing a photopolymer printing plate precursor, the method comprising providing an embodiment of the apparatus as described herein, and performing the operations as described herein using the same. Specifically, the method includes backside curing the first portions of the photopolymer plate precursor while the plate precursor is disposed at least in part on the plate holder, and performing the imaging operation, the frontside curing operation, the uncured photopolymer removal operation, the aftertreatment operation, and the optional detacking operation, while the plate precursor is disposed on the drum.

The backside curing operation may be performed before the plate is loaded on the drum, during unloading of the plate from the drum, or sequentially after performance of the plate imaging operation and before the frontside curing operation.

### BRIEF DESCRIPTION OF THE DRAWINGS

FIG. 1 is a schematic drawing depicting a side view of a thermal processing system of the prior art.
FIG. 2 is a photograph perspective view of a thermal processing system of an exemplary thermal processing system of the prior art.
FIG. 3 is a schematic drawing depicting a side view of one embodiment of the invention including a drum, thermal processing system, and plate holder positioned tangentially adjacent to the drum.
FIG. 4 is a schematic drawing depicting a portion of a plate holder and plate transport embodiment.
FIG. 5 is a schematic drawing depicting a side view of another embodiment of the invention including a drum, thermal processing system, and plate holder positioned tangentially adjacent to the drum.
FIG. 6 is schematic drawing depicting a perspective overhead side view of an embodiment of the invention including a drum and loading and unloading plate holders positioned tangentially adjacent to the drum.
FIG. 7 is schematic drawing depicting a side view of an embodiment of the invention including a drum, thermal processing system, and plate holder positioned tangentially adjacent to the drum, with a repositionable frontside / backside radiation source.

### DETAILED DESCRIPTION OF THE INVENTION

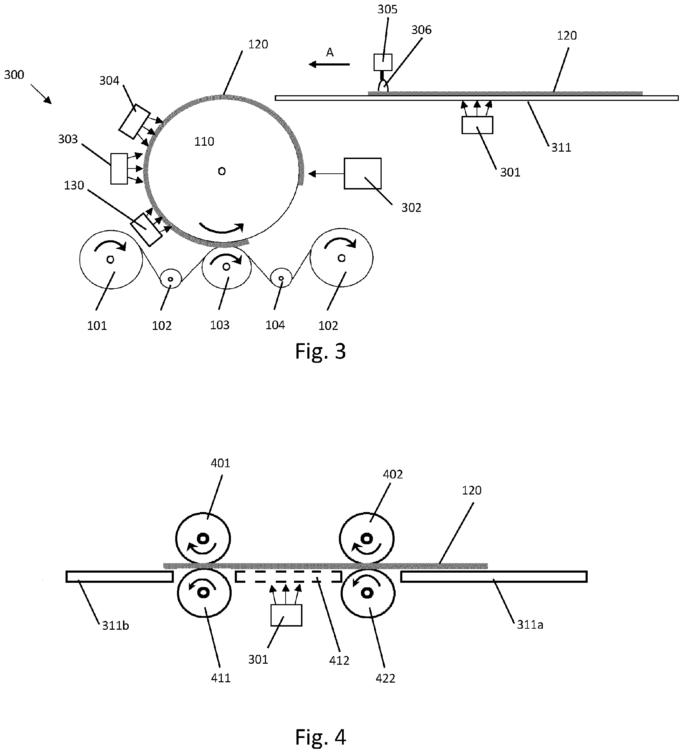

Fig. 3 schematically depicts an exemplary plate processor, including a thermal processing system as described above, extended with additional processing devices 301, 302, 303 and 304, as described further below. The exemplary system is configured to process a plate precursor into a finished printing plate. As used herein (especially in the claims), the term "plate precursor" refers to the unimaged, unexposed printing plate prior to any processing steps, as well as to an incomplete or in-process printing plate after performance of some but not all processing steps required to make the plate ink-ready. The terms "finished" or "complete" or "ink-ready" may be used to refer to plates that have been fully processed through imaging, exposure, uncured-polymer removal, and aftertreatment and/or detacking operations. It should be understood that while additional processing steps may be performed on a finished plate, such as cutting into patches and assembly of those patches onto a substrate for the actual printing step, the finished plate is ink-ready after completion of the operations prior to cutting. It should be also understood that the terms "printing plate" or plate may also be used herein at times in shorthand to refer to the incomplete, non-ink-ready precursor, where the actual state of the plate should be clear to one of skill in the art according to the context of the reference.

One aspect of the invention relates to an apparatus for producing digital flexographic photopolymer printing plates capable of executing all process steps for production of the printing plate (except cutting the plate into patches) using the apparatus. The apparatus employs a rotating cylinder, hereinafter referred to as a "drum," for executing the majority of the process steps, except back exposure of the plates applied during loading and/or unloading the plate to or from the drum. The apparatus includes all radiation sources needed for curing the polymer and all components used in thermal processing of the plate.

In addition to the advantageous reduction in footprint of the apparatus as compared to multiple machines otherwise required to perform the process steps, the apparatus makes execution of the individual processing steps more efficient and reliable, as all components of the apparatus may be controlled by a single central controller.

The processing steps executed in the apparatus as described herein include:
- backside exposure (to create the floor of the photopolymer plate);
- imaging of the mask layer (to define the printing areas of the plate by removing portions of the mask in accordance with a digital image that defines openings to be made in the mask);
- UVA curing of the photopolymer plate through the removed portions of the mask;
- removal of non-cured portions of the photopolymer plate;
- UVA finishing; and
- optional UVC de-tacking.

### Backside exposure

As shown in FIG. 3, backside UVA radiation source 301 is positioned for curing the backside of the plate 120 while the plate is moved on a holder 311 towards the drum in direction of arrow A. Holder is transparent or at least partially transparent to the wavelength emitted by the source. In a preferred embodiment the holder is made of glass or a polymer sheet (e.g. acrylic) that has low absorption in the UVA range. In some embodiments only the portion of holder 311 between radiation source 301 and the plate is made of transparent material (i.e. in the form of a window) while the rest is non-transparent. The plate is typically moved continuously at a constant speed to achieve a constant overall floor thickness. Therefore, the movement of the plate on the holder 311 is decoupled from the rotation of the drum. In one embodiment, the plate is stationary on the holder 311 while the UVA radiation source is moved under the holder along the backside of the plate. In embodiments with transparent windows, this means the window is at least the size of the entire portion of the largest plate intended to be exposed by the device and the apparatus is configured to place the plate in a position on top of the window. In another embodiment, the movement of the polymer plate is executed by means of a moveable bar 305 that holds the plate by means of multiple suction cups 306 arranged along the bar which are activated by vacuum (e.g. absolute air pressure below 1000 mbar). The vacuum or low air pressure may be generated by any means known in the art, including venturi systems that use compressed air to generate suitable vacuum. The bar with the suction cups drags the entire length of the plate over the stationary UVA backside radiation source (e.g. which emits radiation through the holder or through a window in the holder).

In yet another embodiment, the plate may be dragged by the suction cups over the backside UVA radiation source in direction A towards the drum. When the leading edge of the plate reaches the drum, the plate is handed over from the suction cups to the drum. The plate is fixed to the drum surface, for example by vacuum, and the drum continues to drag the plate over the UVA radiation source. The moment of handing over the plate may be timing sensitive. Optionally, the backside radiation source may be configured to be switched off for the time that is needed to hand over the plate from the suction cups to the drum and to be switched back on when the drum is ready to continue dragging the plate, so that the area of the plate disposed above the source during the handoff does not receive materially more radiation than is desired (i.e. no more than the remaining areas of the plate).

Alternatively, as depicted in Fig.4, two pairs of rotating nip rollerspair 401, 411 and pair 402, 422 - may be used to move the plate 120 over the radiation source 301 in direction A at a constant speed. Also depicted in Fig. 4 is an opening of the holder between the plate and the radiation source 301 in which window 412 and the pairs of rollers are disposed. Window 412 may comprise a glass or another transparent or partially transparent material as described above. In embodiments in which the opening between rollers is sufficiently small and material properties of the plate precursor are sufficient stiff, the opening may be open between with source and the backside of the plate, with no material disposed therebetween. Thus, the term "window" as used herein may refer to an opening with no material disposed herein, or a solid material that is at least partially transparent to the actinic radiation. In embodiments, the holder is divided into three parts (first portion 311a, window portion 412, second portion 311b) that are intersected by the pair of drive rollers 402,422 between the first portion and the open portion and by the pair of drive rollers 401,411 between the open portion and the second portion 301b. In a preferred embodiment only one of each pair of nip rollers is driven by a motor while the other one is free running. Both driven rollers are mechanically connected, e.g. a timing belt, or a chain to ensure identical rotation speed. Such an arrangement allows continuous plate movement over the backside radiation source while the plate is attached to the drum and may facilitate a less complicated handoff than systems comprising a bar and suction cups.

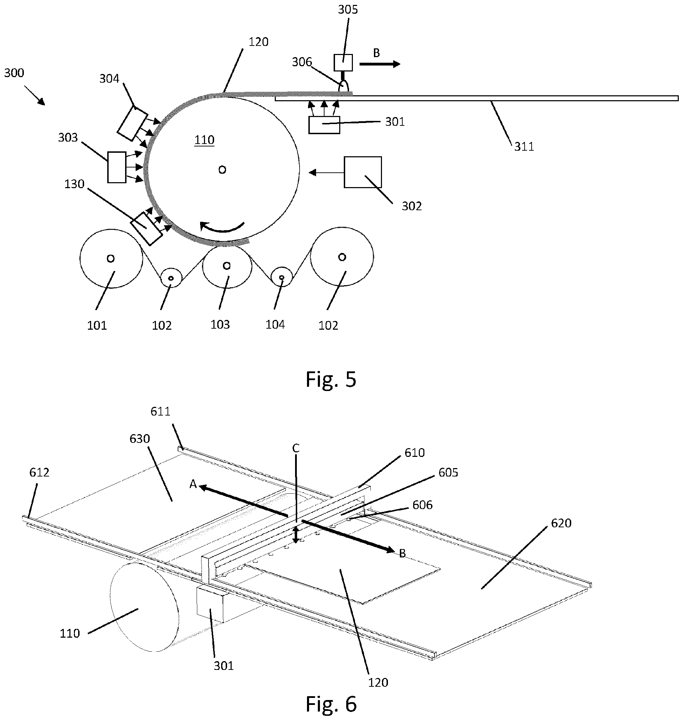

In a preferred embodiment, the plate is loaded almost completely onto the drum first. After that, the suction cups pick up the plate end which is not yet completely loaded to the drum und move the plate in direction B completely over the backside radiation source, as depicted in Fig. 5, thus moving the drum opposite its normal rotation direction (in which case the drum rotating mechanism is switched into a neutral or reverse mode) . The advantage of this setup is the continuous movement of the plate without the need to hand over the plate while at the same time the plate holder only needs little more space than the size of the plate. Moreover, this configuration permits performance of the backside exposure step after the imaging step, directly before execution of the frontside main exposure step.

The scope of the invention is not limited to the foregoing examples, and other embodiments may be provided.

### Imaging

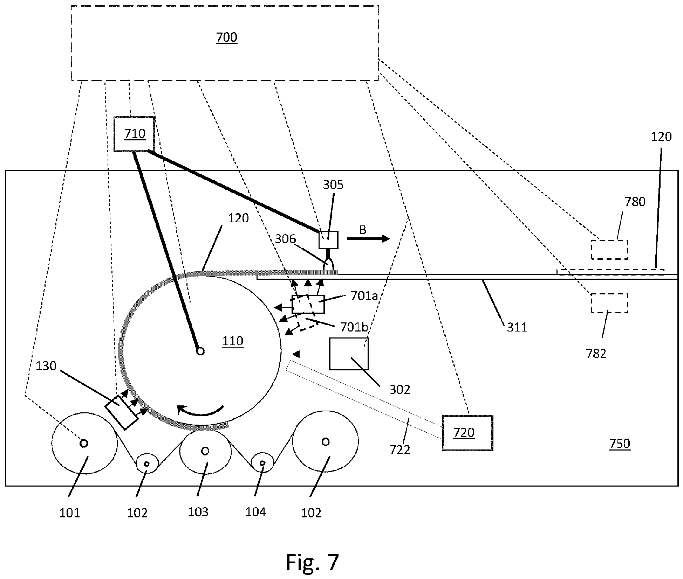

As described herein above, the plate is mounted on the rotating drum in some manner after, during, or before the backside exposure step. The mounting can be established by a clamping system integrated into the drum, vacuum applied to the drum surface, by the fixation system discussed herein later, combinations thereof, of any means known in the art. After the plate has been loaded and fixed to the drum, the plate is imaged by imaging system 302. The imaging system comprise a laser source that produces one or more (typically a multitude of) imaging beams at a wavelength suitable for ablating the LAMs of the digital photopolymer plate. During imaging, the drum typically rotates at a speed of several hundred RPM while the imaging beams travel parallel to the drum axis along the plate surface. An air extraction system 720 (not shown in FIG. 3, to reduce clutter, but depicted in FIG. 7) removes dust and fumes generated by the ablation process (e.g. via a hose 722 disposed sufficiently close to the particulate and fumes generated by the laser ablation to pull the airborne waste into the extraction system for disposal and/or treatment).

In the embodiment depicted in Fig. 5, the first processing step may be the imaging step. After imaging, the plate is unloaded by the moveable bar 305 from the drum and transported again in direction of arrow B over the holder 311. During unloading and transporting, the backside of the plate is exposed to UVA radiation through the transparent holder 311 or a transparent portion of the holder. Immediately after the backside of the plate is completely exposed, the plate is reloaded to the drum again and the front side exposure is applied through the revealed portions of the LAMS. This sequence of process steps allows a shorter delay time between the back and front exposure of the plate, which is advantageous for forming the support shoulders of small printing dots on the plate, as is described in more detail in EP3368949A2, titled SYSTEM AND METHOD FOR CONTROLLED EXPOSURE OF FLEXOGRAPHIC PRINTING PLATES, assigned to the assignee of the present application, and incorporated herein by reference.

### Front side exposure

After imaging, the plate is partially cured from the front side by UVA radiation from a front side radiation source 303. Source 303 is preferably a linear source which extends along the length of the drum in an axial direction. All areas on the photopolymer plate where the LAMS was removed during the laser process are cured and resolve to printing shapes on a fully-processed plate. Using an automated sequence of backside-exposure/imaging/frontside-exposure, or in an alternate embodiment imaging/backside-exposure/frontside-exposure, a constant time delay is preferably established between back and front exposure, which is desirable for the reasons described in EP3368949A2, as noted herein above. Furthermore, the edge of the plate where the back exposure commences is preferably later the same edge where front exposure commences, for best consistency in the back/front exposure time delay across the entirety of the plate. In particular, performing the sequence imaging/backside-exposure/frontside-exposure may be most preferred for providing the most reliable control of consistent time delay. Systems as described herein may have controllers programmed to execute only one of the foregoing sequences or may be configurable to execute either of the sequences (or others), per the specification of a user. The invention is not limited to performance of, or to systems configured to perform, any particular sequence.

One advantage of UV curing on a drum embodiment is the automated return of the UV source to the starting position as the drum rotates through a complete rotation. By contrast, repeated back-and-forth movement of UV radiation sources may be needed in a flatbed UV curing embodiment for shaping the dot tips. Using a drum configuration thus permits curing of the polymer plate in less time than a conventional flatbed-exposure device, especially one implemented on a separate apparatus from the imaging system. Another advantage of the drum curing is that the drum rotation speed can be varied from very slow (e.g. < 1 RPM) to very fast (e.g. >400 RPM). This offers another degree of freedom for shaping the printing dot tips between flat and round tips, which is not practical in existing flatbed embodiments.

### Thermal processing

After imaging and curing, the drum is slowed down to a very low (e.g. between 0.5 - 2) RPM and the plate surface is heated by the thermal heater 130. The typical temperature range for melting uncured photopolymer is between 60 and 160°C. To avoid overwarming the drum, the drum may have a cooling system, such as a water-cooled or air-cooled cooling system. In drum embodiments that use vacuum at least in part for fixing the plate to the drum, air cooling may be applied by opening a bypass valve of the vacuum system that draws cooler ambient air through the drum and into the vacuum source. For drum systems in which the plate is fixed only by clamps or other fixation mounts (i.e. has no vacuum), the drum may be cooled by compressed air that is guided through finned channels (not shown) in the drum. Alternatively, the drum temperature may be stabilized by fans that push air though finned channels in the drum. The thermal processing embodiment as described herein is only an example of one simple embodiment as described in patent EP2112556A1, titled METHOD AND APPARATUS FOR THERMAL DEVELOPMENT WITH A CONFORMABLE SUPPORT, incorporated herein by reference. Other thermal processing embodiments may be used, and the invention is not limited to the use of thermal processing systems.

### UVA Aftertreatment

After all non-cured portions of polymer have been removed from the plate, front side UVA radiation source 303 may be activated again while the drum is rotating. This so-called after-treatment ensures all portions of polymer on the plate are completely cured. As with main UVA curing, various rotation speeds of the drum may be selected to perform this after-treatment step.

### UVC Detacking

An additional radiation source 304 comprising UV LEDs emitting in the UVC spectrum may also be arranged (e.g. next to the UVA radiation source 303, as depicted in Fig 3 and Fig. 5). As is generally understood in the art, UVA relates to the wavelength range 315-400 nm and UVC relates to the wavelength range 100-280 nm. This UVC source is used for a processing step typically referred to as "detacking." Detacking removes surface tackiness of the plate for some types of photopolymer. Without detacking on plates having such photopolymer, dust and small particles may stick to the plate surface and affect the quality of the print result. Other advantages of using UVC treatment are also known. In an alternate embodiment, the frontside UV unit 303 may be additionally equipped with UVC LEDs, such as the combined UVA/UVC units described in published application WO2023/089374, referenced herein above. In other embodiments, the LEDs in source 303 may be configurable to emit in UVC or UVA wavelengths, depending upon a control signal provided to the LEDs by a controller. In another alternative embodiment, radiation source 304 may comprise one or more UVC fluorescent tubes. The step of detacking may be combined with the step of UVA aftertreatment or alternatively, it may be executed separately. In a preferred embodiment UVC and UVC curing steps are combined, to achieve a lesser overall processing time per plate.

### Mechanical embodiments and workflow options

The apparatus as described herein permits fully automated processing of photopolymer printing plates using a single apparatus. Unlike existing prior art systems and workflows in which each processing step is executed in a separate apparatus, with only a few but not all of the processing steps as described herein combined in one apparatus, embodiments of the apparatus as described herein comprises all processing steps to form a print-ready plate from a blank, digital printing plate with an unimaged LAMs layer. The apparatus as described has a much smaller footprint as compared to the sum all individual processing stations required for the complete processing in prior art systems. Arrangement of all processing steps around the central drum simplifies and minimizes plate handling and transportation, thus significantly reducing the time required to transport the plate from one processing station to the next in a conventional arrangement having multiple processing stations. These time savings partially compensate for the fact that the total output of plates per unit time in an apparatus as described herein is lower than in a setup having multiple individual processing stations that are capable of processing plates simultaneously.

The embodiment as described herein in which the backside curing of the plate is executed while the plate is completely located on the horizontal holder during the backside curing needs more floorspace and more material for housing and movement axis but offers a simpler and potentially more reliable way of executing the backside curing of the plate. The embodiment as described herein in which the backside of the plate is cured partially on the drum while the other part is on the horizontal holder needs less floor space but requires more effort for the movement of the plate, especially for the backside exposure.

In another embodiment of the apparatus, depicted in Fig 6, the plate 120 is loaded on the drum 110 from the surface of holder 620 on the right side, while the completely processed plate is unloaded from the drum to holder 630 on the left side. Radiation source 301 is located below a section of holder 620 that is transparent to UVA radiation for curing the plate backside with UVA radiation. In this embodiment, the transportation of the plate from the holders to the drum 110 and vice versa is executed by a traverse 610 that holds bar 605 equipped with the suction cups 606. The traverse is attached with linear bearings (not visible) to rails 611 and 612 that allow movement of the traverse laterally relative to the drum in directions A and B. The bar can also be moved up and down in direction C (i.e. perpendicular to the plate holder) to pick up one end of the plate 120 close to the plate's edge and transport the plate from holder 620 to the drum for loading the plate onto the drum or to unload the plate from the drum. Optionally, bar 605 can be rotated in the plane of the plate holder (i.e. on an axis perpendicular to the plate holder) to correct angular misplacement of the plate with respect to the drum axis. This feature also facilitates aligning the plate edge with fixation means on the drum surface.

In another embodiment, plate 120 is loaded onto drum 110 from the surface of holder 620 on the right side (as depicted in Fig. 6) and the completely processed plate is unloaded from the drum onto the same holder 620. In both embodiments, each plate to be processed is placed manually on holder 620 and can be removed manually from holder 620, respectively, by a human operator. In the embodiment unloading plates on holder 630 a storage basket may be used to store multiple processed plates before they are removed by an operator.

Both embodiments may also be configured to be supplied with plates automatically e.g. by a robot that automatically takes plates from (e.g. a high-bay) storage. Optionally, an automated transportation system may transfer processed plates to a cutting table, where individual patches may be cut from the plate or the plate may otherwise be further processed by the cutter.

Movements of the component parts of apparatus as described herein may be initiated by commonly known components, including but not limited to electrical motors, timing belts, gear wheels, compressed air actuators, and the like, without limitation. The invention is not limited to any particular implementation of or mechanisms for performing the functions as described herein.

In another embodiment, depicted in Fig. 7, the UVA radiation source may occupy two positions, represented by source positions 701a and 701b. In position 701a, the radiation source is arranged to apply back side curing to the plate's back side. In position 701b, the radiation source is arranged to apply front side curing to the plate's front side.

Fig. 7 also depicts additional components (not depicted in Figs. 1-6 to reduce clutter, but which may also be present in any of the systems as described herein). For example, FIG. 7 depicts an enclosure 750 that encloses the drum, the thermal processing system, the plate holder, and all of the various other components of the apparatus. The enclosure may enclose all of the components, or fewer than all of the components. For example, the plate holder may not be disposed within the enclosure (but a separate enclosure may be disposed at least over the radiation source and the radiation path to limit human exposure to the radiation).

Fig. 7 also depicts controller 700, which is schematically depicted as communicatively connected to each of the components of the apparatus. It should be understood that this schematic depiction is merely intended to represent some communicative connection to the relevant component system, which may be a wired or wireless connection, and additional control means may be interposed between the controller and the components depicted. For example, controller 700 is depicted as connected to roller 101, but it should be understood that this connection is intended to represent a connection to the uncured polymer removal system as a whole, which may have its own control system (not shown) that is controlled in accordance with control signals from controller 700. Controller 700 is also depicted connected to the heater 130 of the thermal processing system, to drum 110, to source positions 701a and 701b, to transport system 305, to imaging laser 302, as well as to air handling system 710 and fume disposal system 720, and likewise, any of these components may have their own controllers that interface with controller 700.

Air handling system 710 may be a vacuum system for pulling a vacuum on drum 110 that helps retain the plate on the drum, which system may also be connected to the transport system 305 for control of suction cups 306, and which system may also be used for air cooling of the drum, as described herein. The air handling system may perform fewer than all of the above functions, or separate systems may be configured to perform each function, each of which is controlled by controller 700. It should be understood that the depicted connection to the controller and between the air handling system and other components is schematic only, and that other components (not shown) may be included in the respective systems and controlled by the controller. For example, the operation of the air handling system to control suction cups 306 may comprise one or more solenoid valves controlled by the controller for introducing the vacuum or air to the air handling system as needed. Embodiments may include a compressor in which vacuum is supplied from the suction side of the compressor and pressurized (i.e. compressed) air is supplied from the pressurized side of the compressor. Systems for introducing compressed air through a venturi may also be used to provide vacuum wherever needed, rather than using suction side connections.

Although shown connected to the drum, generally, the controller may be configured to control rotation direction and speed of the drum, as well as any clamping systems on the drum, and/or dedicated cooling and/or vacuum systems supplied to the drum. Each of the systems as described herein may include various sensors and instruments (not shown) connected to the controller, for providing information used for feedback and/or feed forward control of the apparatus.

Controller 700 preferably comprises a computer processor connected to computer memory embodying non-transitory machine-language program instructions readable by the processor for causing the processor to coordinate the performance of the various operations as described herein that the apparatus is configured to perform, in the sequence of operations as described herein (or in any sequence as known in the art). Controller 700 may further be configured to operate the components of an inspection system 780, 782 (described herein below), in which case the processor may be further configured to process the captured image information for performing the inspection operation as described. It should be understood as used herein, the term "processor" may refer to a single processor, multiple processors, or discrete portions or modules of a processor, without limitation, which processor may be local or connected to the apparatus over a network, or some combination thereof.

In one embodiment of the invention, the apparatus is designed to use a plate fixation system substantially similar or identical to fixation systems used in printing presses, such as is described in, e.g., US11628663B2, titled FLEXOGRAPHIC PRINTING IMAGING WITH LEAD AND TRAIL EDGE STRIPS, incorporated herein by reference, which includes a leading-edge connector and a trailing-edge connector added to the respective edges of the plate. The connectors have a plurality of apertures and are configured to interface with mating features on corresponding "lock formations" mounted to, e.g., a print cylinder, drum, or other plate transport mechanism. The connectors as described therein, when applied to a plate, allow the plate to be mounted on a drum with the same type of connection system for processing from a plate precursor to a finished plate as is used for mounting the fully processed, ink-ready printing plate to a print cylinder of a printing press during print jobs when the plate is supplied with ink that is transferred to a print substrate.

A plate fixation system in combination with the apparatus may improve the quality of flexographic printing by reducing inaccuracies that may occur due to the plate mounting, because all plates will be processed completely in all relevant processing steps with mechanical reference to the fixation system. This is an advantage, especially when using sets of multiple plates (i.e. separations) for color prints. Certain fixation systems may allow attaching and detaching the plate to and from the drum by means of magnetic forces or mechanisms using compressed air. The plate may be disposed on the drum by any means known in the art, including but not limited to clamps, vacuum, special fixation mechanisms (such as but not limited to those described herein), bars attached to the plate and fixed to the drum by magnetic forces or other mechanisms, and combinations thereof. The invention is not limited to any particular fixation system or by any manner in which the plates are fixed to the drum.

Optionally, an inspection tool, such as a camera-based tool for analyzing imaging quality (e.g. to check proper focus position of imaging beams and properties of the printing dots on the completely processed plate) may be implemented into the apparatus to monitor the quality before, during, or after unloading the plate. For example, as illustrated in FIG. 7 schematically, the plate 120 may remain on holder 311 and inspection camera 780 may be disposed on a traverse configured to move relative to different spots on the plate. In such embodiments, the holder (or a portion thereof) may be transparent to visible light (or any wavelength suitable for inspection) and a source of the inspection light 782 may be located beneath (or within) the holder and configured to emit the light through the transparent portion of the holder and through the plate for illumination of at least the portion of the plate under inspection. The illumination may cover an entirety of the plate, or only the portion of the plate under inspection.

In addition to the various advantages of the different embodiments as described herein above, embodiments of the invention may also have additional advantages. For example, many parts may become obsolete (housings, power supplies, central processing units, control units, sensors used for the different machines no longer needed). Communication and coordination between individual process steps will be less complicated, because they can all occur on a single device operated by a single controller. Installation effort for the device will be less than the installation efforts for multiple machines, each performing fewer than all of the process steps. Data logging and failure analysis in the process are simplified. Management Information Systems may be more easily updated regarding the process status of a particular plate. As all processing parameters are handed over to one apparatus, mixing up information during processing becomes very unlikely, which reduces plate waste and redoing jobs due to process communication failures.

Although the invention is illustrated and described herein with reference to specific embodiments, the invention is not intended to be limited to the details shown. Rather, various modifications may be made in the details within the scope and range of equivalents of the claims and without departing from the invention.

## Claims

1. An apparatus for processing a photopolymer printing plate precursor having a frontside and a backside, the plate precursor comprising a photopolymer layer and a Laser Ablatable Mask system (LAMs) layer on the frontside of the plate precursor, the apparatus comprising a drum configured to receive and hold the plate precursor during at least some of a plurality of plate precursor processing operations, a plate holder arranged tangentially adjacent to the drum for receiving the backside of the plate precursor during a loading and/or unloading step of the plate, and a controller configured to control execution of the plurality plate precursor processing operations by the apparatus, the apparatus comprising:
at least one first radiation source configured to emit actinic UVA radiation during a backside curing operation of first portions of the photopolymer plate precursor performed with the backside of the plate precursor disposed at least in part on the plate holder and the first radiation source positioned beneath the plate holder and arranged to emit radiation through a window in the plate holder onto the plate precursor backside;
a laser imaging system comprising one or more laser light sources configured for laser imaging the LAMS layer during an imaging operation performed with the plate precursor disposed on the drum;
at least one second radiation source configured to emit actinic UVA radiation during a frontside curing operation of second portions of the photopolymer plate precursor through the imaged LAMS layer performed with the plate precursor disposed on the drum;
a processing system configured to perform an uncured photopolymer removal operation of uncured photopolymer from the plate precursor performed with the plate precursor disposed on the drum; and
at least one third radiation source configured to emit actinic UVA radiation during an aftertreatment operation on the plate precursor performed with the plate precursor disposed on the drum, optionally wherein the at least one third radiation source is a same source as the at least one second first radiation source;
optionally, further comprising at least one fourth radiation source configured to emit actinic UVC radiation during a detacking operation performed with the plate precursor disposed on the drum, optionally wherein the fourth radiation source comprises a plurality of LEDs or fluorescent tubes.

2. The apparatus of claim 1, wherein each of the first, second, and third radiation sources comprises a plurality of LEDs.

3. The apparatus of any one of the foregoing claims, wherein the plate holder has a length suitable to accept an entire length of the plate precursor, wherein the apparatus, including the controller, is configured to perform the backside curing operation during unloading of the plate from the drum.

4. The apparatus of any one of the foregoing claims, wherein the window in the plate holder comprises a material at least partially transparent to the actinic radiation emitted by the first radiation source, and the apparatus includes a moveable bar equipped with suction cups operable to removably attach the suction cups to the frontside of the plate precursor, the bar configured to move relative to the plate holder and configured to perform the back exposure of the plate by dragging the plate over the window during the backside exposure operation.

5. The apparatus of any one of the foregoing claims, further comprising a plate fixation system disposed on the drum that interfaces with a mating plate fixation mechanism on the plate precursor, wherein the plate fixation mechanism disposed on the plate precursor is also suitable for fixing an ink-ready printing plate formed from the plate precursor to a printing cylinder of a printing press.

6. The apparatus of any one of the foregoing claims, wherein the first radiation source and the second radiation source comprise a single radiation source having a first configuration aimed toward the window in the plate holder and a second configuration aimed toward the drum.

7. The apparatus of any one of the foregoing claims, wherein the plate holder has a first solid portion and a second solid portion, wherein the window comprises an opening in which are disposed a first pair of nip rollers adjacent the first solid portion and a second pair of nip rollers adjacent the second solid portion, each of the first pair and the second pair configured to receive the plate precursor therebetween, wherein the first radiation source is disposed between the first pair of nip rollers and the second pair of nip rollers.

8. The apparatus of any one of the foregoing claims, wherein the processing system for removing uncured photopolymer comprises a thermal processing system.

9. The apparatus of claim 8, wherein the thermal processing system comprises a roller system configured to transport a web to and from a contact area between the plate and the web, the contact area located between a pressure roller and the drum, and a heater disposed sequentially before the contact area, wherein the heater is configured to heat the plate precursor to a temperature at which uncured polymer in the plate precursor is liquified or otherwise disposed to detach from the plate precursor and attach to the web but at which the cured polymer remains in a solid state disposed to remain attached to the plate precursor.

10. The apparatus of claim 9, wherein the drum further comprises a cooling system for maintaining a temperature of the drum at a desired temperature during repeated heating of the plate mounted on the drum, optionally further comprising an enclosure surrounding at least the drum, and a fume evacuation system configured to remove fumes and/or particulate from within the enclosure during performance of the imaging operation.

11. The apparatus of any one of claims 1-10, wherein the apparatus, including the controller, is configured to execute the backside curing operation before the plate is loaded on the drum.

12. The apparatus of any one of claims 1-10, wherein the apparatus, including the controller, is configured to execute the backside curing operation sequentially after performance of the plate imaging operation and before the frontside curing operation.

13. A method for processing a photopolymer printing plate precursor comprising a photopolymer layer and a Laser Ablatable Mask system (LAMs) layer, the method comprising:
a) providing the apparatus of any one of claims 1-10; and
b) performing the operation for backside curing the first portions of the photopolymer plate precursor while the plate precursor is disposed at least in part on the plate holder;
c) performing the imaging operation on the plate precursor while the plate precursor is disposed on the drum;
d) performing the operation for frontside curing the second portions of the photopolymer plate precursor through the imaged LAMS layer while the plate precursor is disposed on the drum;
e) performing the operation for removing uncured photopolymer from the plate precursor while the plate precursor is disposed on the drum;
f) performing the aftertreatment operation on the plate precursor while the plate precursor is disposed on the drum; and
g) optionally performing the detacking operation using the apparatus while the plate precursor is disposed on the drum.

14. The method the claim 13, comprising performing the backside curing operation before the plate is loaded on the drum.

15. The method the claim 13, comprising performing the backside curing operation during unloading of the plate from the drum.

16. The method of claim 15, comprising performing the backside curing operation sequentially after performance of the plate imaging operation and before the frontside curing operation.
